(19)

Europäisches
Patentamt
European
Patent Office
Office européen
des brevets

(11) **EP 3 866 046 A1**

(12) **EUROPEAN PATENT APPLICATION**

(43) Date of publication:
18.08.2021 Bulletin 2021/33

(51) Int Cl.:
**G06F 30/23** (2020.01)

(21) Application number: 21150560.7

(22) Date of filing: 07.01.2021

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **14.02.2020 JP 2020023151**

(71) Applicant: **Subaru Corporation**
**Tokyo 150-8554 (JP)**

(72) Inventor: **NAKANO, Takuya**
**Tokyo, Japan 150-8554 (JP)**

(74) Representative: **Sajda, Wolf E.**
**Meissner Bolte Patentanwälte**
**Rechtsanwälte Partnerschaft mbB**
**Postfach 86 06 24**
**81633 München (DE)**

(54) **INTERNAL-LOAD CALCULATION APPARATUS AND METHOD OF CALCULATING INTERNAL
LOAD**

(57) An internal-load calculation apparatus (100) includes a memory (106) and a calculator (104). The memory (106) stores the results of a preliminary analysis of an internal load exerted on a member of interest (200) in a sound condition. The calculator (104) calculates, on the basis of the distribution of an internal load exerted on the member of interest (200) upon the application of an external load to an element of interest (204b) and the results of the preliminary analysis stored in the memory (106), the distribution of an internal load exerted on the member of interest (200) upon the occurrence of damage on the element of interest (204b). The element of interest (204b) corresponds to at least one of a plurality of elements (204a) of the member of interest (200).

FIG. 1

EP 3 866 046 A1

**Description**

BACKGROUND

1. Technical Field

The invention relates to an internal-load calculation apparatus that calculates an internal load, and a method of calculating an internal load.

2. Related Art

A finite element method has been used to analyze the strength of constituent members of an aircraft in some cases. Reference is made to WO 2018/061280 A1.

SUMMARY

An aspect of the invention provides an internal-load calculation apparatus including a memory and a calculator. The memory is configured to store the results of a preliminary analysis of an internal load exerted on a member of interest in a sound condition. The calculator is configured to calculate, on the basis of the distribution of an internal load exerted on the member of interest upon the application of an external load to an element of interest and the results of the preliminary analysis stored in the memory, the distribution of an internal load exerted on the member of interest upon the occurrence of damage on the element of interest. The element of interest corresponds to at least one of a plurality of elements of the member of interest.

Another aspect of the invention provides a method of calculating an internal load. The method includes obtaining the distribution of an internal load exerted on a member of interest upon the application of an external load to an element of interest and the results of a preliminary analysis of an internal load exerted on the member of interest in a sound condition, and calculating, on the basis of the distribution of the internal load exerted on the member of interest upon the application of the external load to the element of interest and the results of the preliminary analysis of the internal load exerted on the member of interest in the sound condition, the distribution of an internal load exerted on the member of interest upon the occurrence of damage on the element of interest. The element of interest corresponds to at least one of elements of the member of interest.

BRIEF DESCRIPTION OF THE DRAWINGS

The accompanying drawings are included to provide a further understanding of the invention and are incorporated in and constitute a part of this specification. The drawings illustrate example embodiments and, together with the specification, serve to explain the principles of the invention.

| | |
|---|---|
| FIG. 1 | is a block diagram of an internal-load calculation apparatus according to one example embodiment of the invention. |
| FIG. 2 | is a schematic diagram illustrating a member of interest. |
| FIGS. 3A to 3F | are schematic diagrams illustrating a first result of a preliminary analysis. |
| FIGS. 4A to 4F | are schematic diagrams illustrating a second result of a preliminary analysis. |
| FIG. 5 | is a flowchart of a process of calculating an internal load according to one example embodiment of the invention. |
| FIG. 6 | is a table of the measurement results of the preliminary analysis. |
| FIGS. 7A to 7C | are diagrams illustrating a first modification example of the invention. |
| FIGS. 8A to 8D | are diagrams illustrating a second modification example of the invention. |
| FIGS. 9A to 9C | are diagrams illustrating a third modification example of the invention. |
| FIGS. 10A and 10B | are diagrams illustrating a fourth modification example of the invention. |

DETAILED DESCRIPTION

A process of calculating an internal load exerted on a member of interest upon the application of an external load to the member of interest involves high calculation load. This generates a necessity for development in a technique that reduces a calculation load involved in calculation of an internal load. It is desirable to provide an internal-load calculation apparatus and a method of calculating an internal load that reduce a calculation load involved in calculating an internal load upon the occurrence of damage on a member to be subjected to a strength analysis.

Some example embodiments of the invention will now be described in detail with reference to the accompanying drawings. Note that the following description is directed to illustrative examples of the invention and not to be construed as limiting to the invention. Factors including, without limitation, numerical values, sizes, shapes, materials, components, positions of the components, and how the components are coupled to each other are illustrative only and not to be construed as limiting to the invention.

Further, elements in the following example embodiments that are not recited in a most-generic independent claim of the invention are optional and may be provided on an as-needed basis. The drawings are schematic and are not intended to be drawn to scale. Throughout the present specification and the drawings, elements having substantially the same function and configuration are denoted with the same numerals to avoid any redundant description. Additionally, the illustration of components not directly relevant to the invention is omitted.

As described above, a process of calculating an internal load exerted on a member of interest upon the application of an external load to the member of interest involves high calculation load. According to an example embodiment of the invention described below, it is possible to reduce the calculation load involved in calculating an internal load. For example, it is possible to reduce a calculation load involved in calculating an internal load exerted on a member of interest upon the occurrence of damage on the member of interest.

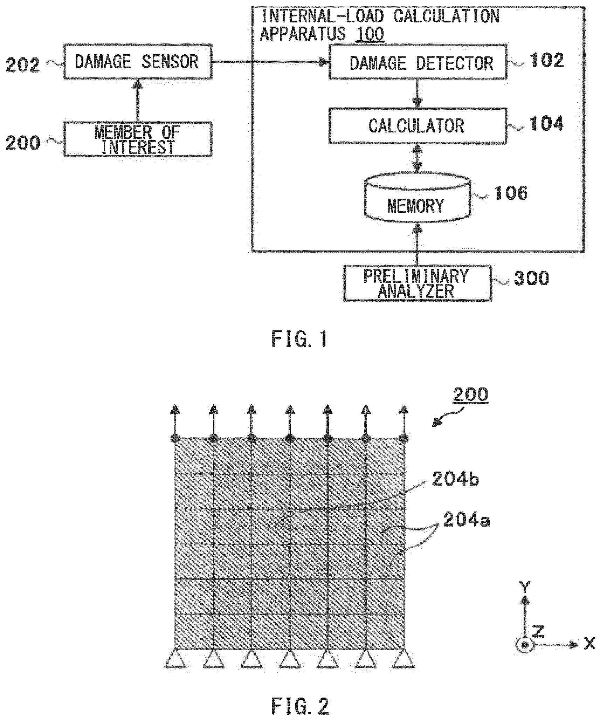

FIG. 1 is a block diagram of an internal-load calculation apparatus 100. As illustrated in FIG. 1, the internal-load calculation apparatus 100 may include a damage detector 102, a calculator 104, and a memory 106. For example, the internal-load calculation apparatus 100 may be a personal computer including a semiconductor circuit provided with a central processing unit (CPU), a read only memory (ROM) storing programs or the like, and a random access memory (RAM) serving as a work area.

Executing the programs may cause the damage detector 102 and the calculator 104 to operate. The memory 106 may be a hard disk or a flash memory including an non-volatile memory element, for example. The memory 106 may store the results of an analysis of a member of interest 200 by a preliminary analyzer 300.

The internal-load calculation apparatus 100 may be coupled to a damage sensor 202 and the preliminary analyzer 300. The damage sensor 202 may detect the occurrence of damage on the member of interest 200 the internal load of which is to be calculated.

In the case of an aircraft, the damage sensor 202 may detect the physical quantity of the member of interest of the aircraft while the aircraft is flying, for example. The physical quantity to be detected by the damage sensor 202 may be a given physical quantity that changes upon the occurrence of damage on the member of interest.

Representative examples of the physical quantity that are readily detected upon the occurrence of damage on the member of interest may include the amount of distortion, the amount of vibration, and the acceleration rate of the member of interest. The damage sensor 202 may detect at least one of the amount of distortion, the amount of vibration, or the acceleration rate of the member of interest.

The preliminary analyzer 300 may preliminarily analyze the member of interest 200 to obtain the distribution of an internal load exerted on the member of interest 200 in a sound condition. Thereafter, the preliminary analyzer 300 may accumulate the results of the analysis of the member of interest 200 in the memory 106. Accordingly, when calculating an internal load, the internal-load calculation apparatus 100 may only have to retrieve the results of the analysis of the member of interest 200 preliminarily stored in the memory 106.

FIG. 2 schematically illustrates the member of interest 200. In FIG. 2, the member of interest 200 may be in a sound condition without being damaged. The member of interest 200 illustrated in FIG. 2 may include a plurality of elements 204a. In this example embodiment, the number of the elements 204a may be 36. For the purpose of simplicity of description, the elements 204a may be film elements in this example embodiment.

In this example embodiment, the distribution of the internal load exerted on the member of interest 200 may be calculated when an element of interest 204b out of the elements 204a is damaged.

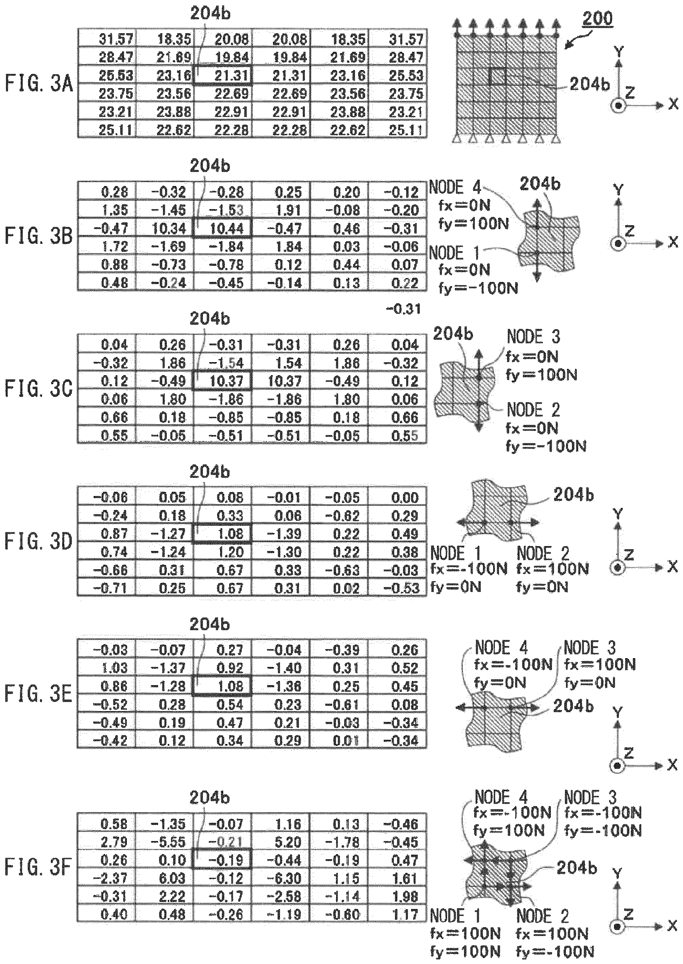

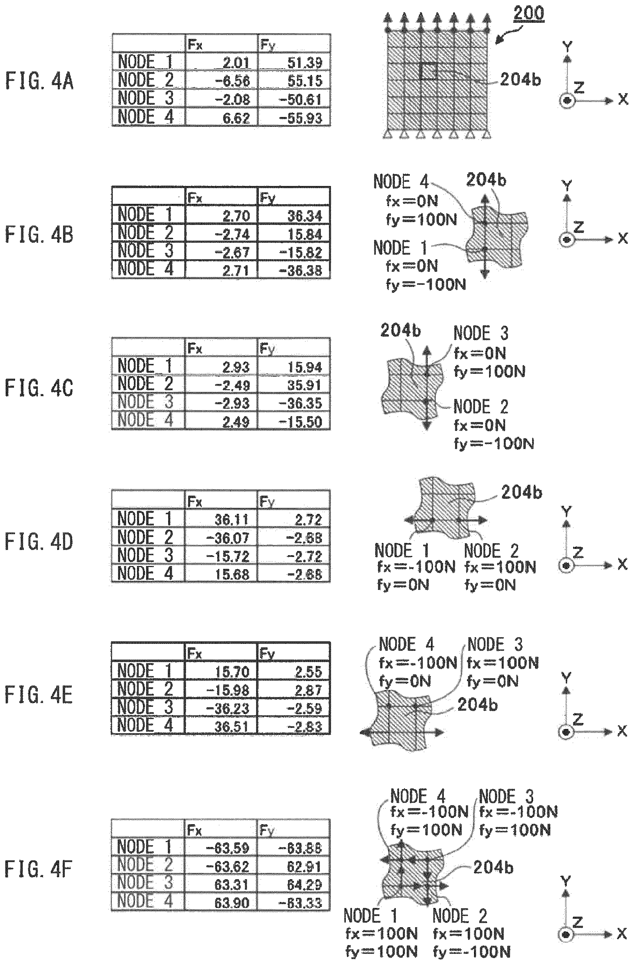

FIGS. 3A to 3F schematically illustrate a first result of the preliminary analysis. FIGS. 4A to 4F schematically illustrate a second result of the preliminary analysis. Note that the preliminary analysis may employ various known methods including a finite element method, for example.

With reference to FIG. 2 and FIG. 3A, the preliminary analysis may start with calculating an internal load exerted on the member of interest 200 in the sound condition by the preliminary analyzer 300. In this example embodiment, a tensile load of 100 N may be applied to each node of the member of interest 200 along a Y-axis to calculate the distribution of the internal load exerted on the member of interest 200.

As illustrated in FIG. 2, the member of interest 200 may be fixed at one end, and a tensile load or an external load may be applied to each node on an opposite end of the member of interest 200 in one direction along the Y-axis.

Note that a numerical value in each column of the tables illustrated in FIGS. 3A to 3F may indicate a Y-axis component of the internal load exerted on each of the elements 204a or the element of interest 204b.

With reference to FIG. 3B, the preliminary analyzer 300 may apply a virtual load to the element of interest 204b to simulate the occurrence of damage on the element of interest 204b. For example, the preliminary analyzer 300 may calculate the distribution of an internal load exerted on the member of interest 200 by applying a tensile load of 100 N to nodes 1 and 4 of the element of interest 204b in respective directions opposite to each other along the Y-axis.

With reference to FIG. 3C, the preliminary analyzer 300 may calculate the distribution of an internal load exerted on the member of interest 200 by applying a tensile load of 100 N to nodes 2 and 3 of the element of interest 204b in the respective directions opposite to each other along the Y-axis.

With reference to FIG. 3D, the preliminary analyzer 300 may calculate the distribution of an internal load exerted on the member of interest 200 by applying a tensile load of 100 N to the nodes 1 and 2 of the element of interest 204b in respective directions opposite to each other along an X-axis.

With reference to FIG. 3E, the preliminary analyzer 300 may calculate the distribution of an internal load exerted on the member of interest 200 by applying a tensile load of 100 N to the nodes 3 and 4 of the element of interest 204b in the respective directions opposite to each other along the X-axis.

With reference to FIG. 3F, the preliminary analyzer 300 may calculate the distribution of an internal load exerted on the member of interest 200 by applying a tensile load to each of the nodes 1 to 4.

For example, the preliminary analyzer 300 may calculate the distribution of the internal load exerted on the member of interest 200 by applying a tensile load of 100 N to the nodes 1 and 2 of the element of interest 204b in one direction along the X-axis, the nodes 3 and 4 of the element of interest 204b in an opposite direction along the X-axis, the nodes 1 and 4 in one direction along the Y-axis, and the nodes 2 and 3 in an opposite direction along the Y-axis.

Thereafter, with reference to FIG. 4A, the preliminary analyzer 300 may calculate the load supported at each of the nodes 1 to 4 of the element of interest 204b in a case where the tensile load of 100 N is applied to each node of the member of interest 200 in the sound condition along the Y-axis on the basis of the result of the preliminary analysis illustrated in FIG. 3A.

With reference to FIG. 4B, the preliminary analyzer 300 may calculate the load supported at each of the nodes 1 and 4 of the element of interest 204b in a case where the tensile load of 100 N is applied to the nodes 1 and 4 of the element of interest 204b in the respective directions opposite to each other along the Y-axis on the basis of the result of the preliminary analysis illustrated in FIG. 3B .

With reference to FIG. 4C, the preliminary analyzer 300 may calculate the load supported at each of the nodes 1 to 4 of the element of interest 204b in a case where the tensile load of 100 N is applied to the nodes 2 and 3 of the element of interest 204b in the respective directions opposite to each other along the Y-axis on the basis of the result of the preliminary analysis illustrated in FIG. 3C.

With reference to FIG. 4D, the preliminary analyzer 300 may calculate the load supported at each of the nodes 1 to 4 of the element of interest 204b in a case where the tensile load of 100 N is applied to the nodes 1 and 2 of the element of interest 204b in the respective directions opposite to each other along the X-axis on the basis of the result of the preliminary analysis illustrated in FIG. 3D.

With reference to FIG. 4E, the preliminary analyzer 300 may calculate the load supported at each of the nodes 1 to 4 of the element of interest 204b in a case where the tensile load of 100 N is applied to the nodes 3 and 4 of the element of interest 204b in the respective directions opposite to each other along the X-axis on the basis of the result of the preliminary analysis illustrated in FIG. 3E.

With reference to FIG. 4F, the preliminary analyzer 300 may calculate the load supported at each of the nodes 1 to 4 of the element of interest 204b in a case where the tensile load is applied to each of the nodes 1 to 4 of the element of interest 204b on the basis of the result illustrated in FIG. 3F.

For example, the preliminary analyzer 300 may calculate the load supported at each of the nodes 1 to 4 of the element of interest 204b in a case where the tensile load of 100 N is applied to the nodes 1 and 2 of the element of interest 204b in the one direction along the X-direction, the nodes 3 and 4 of the element of interest 204b in the opposite direction along the X-axis, the nodes 1 and 4 in the one direction along the Y-axis, and the nodes 2 and 3 in the opposite direction along the Y-axis, on the basis of the result illustrated in FIG. 3F.

In this example embodiment, the element of interest 204b may be subjected to the preliminary analysis described with reference to FIGS. 3A to 3F and 4A to 4F. However, in an actual case, all elements likely to be damaged out of the elements 204a of the member of interest 200 may be subjected to the preliminary analysis. The elements likely to be damaged may correspond to parts of an aircraft exposed outside, for example. Alternatively, all of the elements 204a of the member of interest 200 may be subjected to the preliminary analysis.

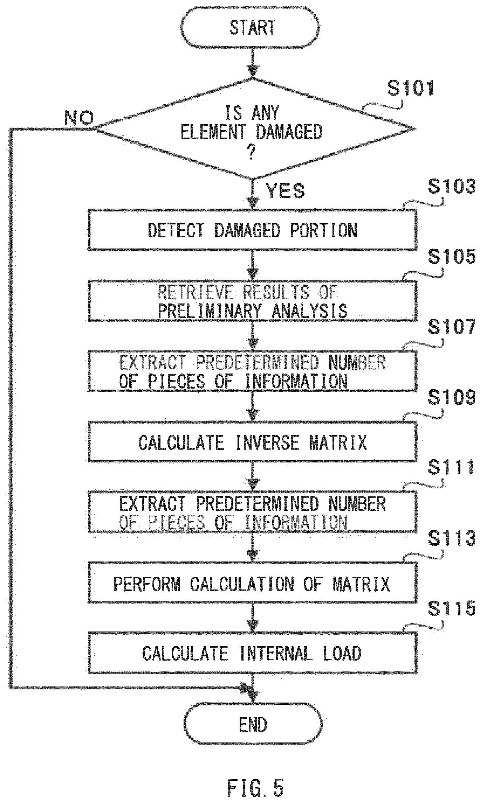

Thereafter, the preliminary analyzer 300 may accumulate the results of the preliminary analysis for each of the elements 204a in the memory 106. FIG. 5 is a flowchart of a process of calculating the internal load.

The damage detector 102 may determine whether any of the elements 204a of the member of interest 200 is damaged on the basis of the results of the detection by the damage sensor 202 (Step S101). If the damage detector 102 determines that any of the elements 204a is damaged (Step S101: YES), the damage detector 102 may acquire information on the damaged portion of the member of interest 200, the scale of the damage, and the like (Step S103). Hereinafter, an example case where the damage detector 102 detects damage on one of the elements 204a (i.e., the element of interest 204b) is described for the purpose of convenience of explanation.

The calculator 104 may retrieve the results of the preliminary analysis stored in the memory 106 (Step S105).

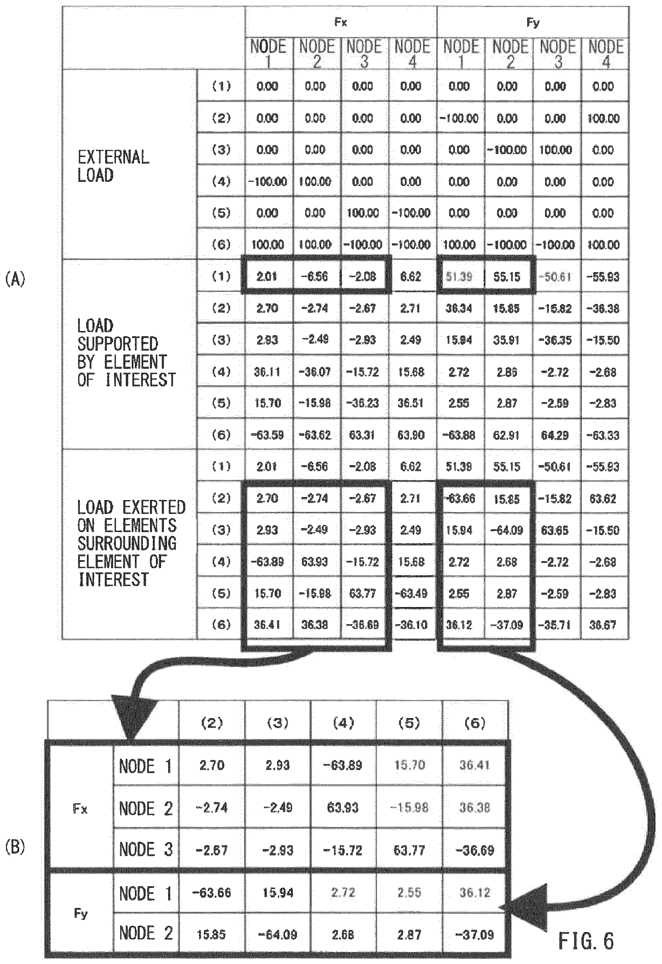

FIG. 6 is a table of the results of the preliminary analysis regarding the element of interest 204b. In this example embodiment, the results of the preliminary analysis illustrated in Part (A) of FIG. 6 may be retrieved.

The calculator 104 may extract a predetermined number of pieces of data from the data on the load exerted on each of the elements 204a surrounding the element of interest 204b (Step S107). The data on the load exerted on each of the elements 204a surrounding the element of interest 204b may be included in the results of the preliminary analysis regarding the element of interest 204b.

For example, in a case where five components are extracted, the calculator 104 may select up to three components from Fx components of the nodes 1 to 4, and up to three components from Fy components of the nodes 1 to 4. That is, in one example, the calculator 104 may select two Fx components from the Fx components of the nodes 1 to 4, and three Fy components from the Fy components of the nodes 1 to 4. In another example, the calculator 104 may select three Fx components from the Fx components of the nodes 1 to 4, and two Fy components from the Fy components of the nodes 1 to 4.

Although the predetermined number is five in this example embodiment, the number of components to be extracted may differ depending on the number or type of elements damaged as described below, for example.

In this example embodiment, three Fx components of the nodes 1 to 3 and two Fy components of the nodes 1 and 2 in terms of external loads (2) to (6) may be extracted and represented in the form of a $5 \times 5$ matrix as illustrated in Part (B) of FIG. 6.

In this example embodiment, the external loads (2) to (6) of Part (A) of FIG. 6 may be combined to simulate the same state in which the element of interest 204b is damaged. For example, the calculator 104 may calculate a combination of the external loads (2) to (6) to exert, on the elements surrounding the elements of interest 204b, the same load as a given load (e.g., the external load (1) of "LOAD SUPPORTED BY ELEMENT OF INTEREST" of Part (A) of FIG. 6) supported by the element of interest 204b.

Thereafter, the calculator 104 may calculate the inverse matrix of the $5 \times 5$ matrix (Step S109). In this example embodiment, the inverse matrix may be calculated as represented by Expression 1 below.

[Expression 1]

$$
\begin{pmatrix}
2.70 & 2.93 & -63.89 & 15.70 & 36.41 \\
-2.74 & -2.49 & 63.93 & -15.98 & 36.38 \\
-2.67 & -2.93 & -15.72 & 63.77 & -36.69 \\
-63.66 & 15.94 & 2.72 & 2.55 & 36.12 \\
15.85 & -64.09 & 2.68 & 2.87 & -37.09
\end{pmatrix}^{-1}
=
\begin{pmatrix}
6.214E{-}03 & 7.398E{-}03 & 1.191E{-}03 & -1.687E{-}02 & -4.254E{-}03 \\
-6.429E{-}03 & -5.244E{-}03 & 1.197E{-}03 & -4.284E{-}03 & -1.681E{-}02 \\
-6.250E{-}03 & 1.055E{-}02 & 4.285E{-}03 & -1.195E{-}03 & -1.189E{-}03 \\
6.369E{-}03 & 1.062E{-}02 & 1.688E{-}02 & -1.190E{-}03 & -1.188E{-}03 \\
1.381E{-}02 & 1.381E{-}02 & 5.498E{-}05 & 1.380E{-}05 & 9.525E{-}05
\end{pmatrix}
\quad \cdots (1)
$$

Thereafter, the calculator 104 may extract a predetermined number of pieces of data on the load supported by the element of interest 204b from the results of the preliminary analysis regarding the element of interest 204b (Step Sill).

In this example embodiment, for example, the Fx components of the nodes 1 to 3 and the Fy components of the nodes 1 and 2 of the load supported by the element of interest 204b in the sound condition in the case of application of the external load (1) may be extracted and represented in the form of a $1 \times 5$ matrix.

Thereafter, the calculator 104 may calculate the product of the inverse matrix and the $1 \times 5$ matrix, as represented by Expression 2 below (Step S113). The right side of Expression 2 may represent the magnitude of a node load (coefficient) necessary to obtain (simulate) a damaged state.

[Expression 2]

$$
\begin{pmatrix}
6.214E{-}03 & 7.398E{-}03 & 1.191E{-}03 & -1.687E{-}02 & -4.254E{-}03 \\
-6.429E{-}03 & -5.244E{-}03 & 1.197E{-}03 & -4.284E{-}03 & -1.681E{-}02 \\
-6.250E{-}03 & 1.055E{-}02 & 4.285E{-}03 & -1.195E{-}03 & -1.189E{-}03 \\
6.369E{-}03 & 1.062E{-}02 & 1.688E{-}02 & -1.190E{-}03 & -1.188E{-}03 \\
1.381E{-}02 & 1.381E{-}02 & 5.498E{-}05 & 1.380E{-}05 & 9.525E{-}05
\end{pmatrix}
\times
\begin{pmatrix}
2.01 \\
-6.56 \\
-2.08 \\
51.39 \\
55.15
\end{pmatrix}
=
\begin{pmatrix}
-1.14 \\
-1.13 \\
-0.22 \\
-0.22 \\
-0.06
\end{pmatrix}
\quad \cdots (2)
$$

Thereafter, the calculator 104 may perform addition of the distribution of the internal load in the sound condition (FIG. 3A) determined by the preliminary analysis and the product of the distribution of the internal load calculated by applying an external load and the coefficient yielded by Expression 2 above, to calculate the distribution of the internal load exerted on the member of interest 200 upon the occurrence of damage on the element of interest 204b (Step S115). The numerical values yielded by Expression 2 above may be used as the coefficients in the addition.

For example, as represented by Expression 3 below, the calculator 104 may perform addition of the internal load in the sound condition (FIG. 3A), the product of the internal load of FIG. 3B and the numerical value or coefficient on the first line of the right side of Expression 2 described above, the product of the internal load of FIG. 3C and the numerical value or coefficient on the second line of the right side of Expression 2 described above, the product of the internal load of FIG. 3D and the numerical value or coefficient on the third line of the right side of Expression 2 described above, the product of the internal load of FIG. 3E and the numerical value or coefficient on the fourth line of the right side of Expression 2 described above, and the product of the internal load of FIG. 3F and the numerical value or coefficient on the fifth line of the right side of Expression 2 described above.

[Expression 3]

| 31.57 | 18.35 | 20.08 | 20.08 | 18.35 | 31.57 |
| 28.47 | 21.69 | 19.84 | 19.84 | 21.69 | 28.47 |
| 25.53 | 23.16 | 21.31 | 21.31 | 23.16 | 25.53 |
| 23.75 | 23.56 | 22.69 | 22.69 | 23.56 | 23.75 |
| 23.21 | 23.88 | 22.91 | 22.91 | 23.88 | 23.21 |
| 25.11 | 22.62 | 22.28 | 22.28 | 22.62 | 25.11 |

$+$

| 0.28 | -0.32 | -0.28 | 0.25 | 0.20 | -0.12 |
| 1.35 | -1.45 | -1.53 | 1.91 | -0.08 | -0.20 |
| -0.47 | 10.34 | 10.44 | -0.47 | 0.46 | -0.31 |
| 1.72 | -1.69 | -1.84 | 1.84 | 0.03 | -0.08 |
| 0.88 | -0.73 | -0.78 | 0.12 | 0.44 | 0.07 |
| 0.48 | -0.24 | -0.45 | -0.14 | 0.13 | 0.22 |

$\times \boxed{-1.14} +$

| 0.04 | 0.26 | -0.31 | -0.31 | 0.26 | 0.04 |
| -0.32 | 1.86 | -1.54 | 1.54 | 1.86 | -0.32 |
| 0.12 | -0.49 | 10.37 | 10.37 | -0.49 | 0.12 |
| 0.06 | 1.80 | -1.86 | -1.86 | 1.80 | 0.06 |
| 0.66 | 0.18 | -0.85 | -0.85 | 0.18 | 0.66 |
| 0.55 | -0.05 | -0.51 | -0.51 | -0.05 | 0.55 |

$\times \boxed{-1.13} +$

| -0.06 | 0.05 | 0.08 | -0.01 | -0.05 | 0.00 |
| -0.24 | 0.18 | 0.33 | 0.06 | -0.62 | 0.29 |
| 0.87 | -1.27 | 1.08 | -1.39 | 0.22 | 0.49 |
| 0.74 | -1.24 | 1.20 | -1.30 | 0.22 | 0.38 |
| -0.66 | 0.31 | 0.67 | 0.33 | -0.63 | -0.03 |
| -0.71 | 0.25 | 0.67 | 0.31 | 0.02 | -0.53 |

$\times \boxed{-0.22} +$

| -0.03 | -0.07 | 0.27 | -0.04 | -0.39 | 0.26 |
| 1.03 | -1.37 | 0.92 | -1.40 | 0.31 | 0.52 |
| 0.86 | -1.28 | 1.08 | -1.36 | 0.25 | 0.45 |
| -0.52 | 0.28 | 0.54 | 0.23 | -0.61 | 0.08 |
| -0.49 | 0.19 | 0.47 | 0.21 | -0.03 | -0.34 |
| -0.42 | 0.12 | 0.34 | 0.29 | 0.01 | -0.34 |

$\times \boxed{-0.22} +$

| 0.58 | -1.35 | -0.07 | 1.16 | 0.13 | -0.46 |
| 2.79 | -5.55 | -0.21 | 5.20 | -1.78 | -0.45 |
| 0.28 | 0.10 | -0.19 | -0.44 | -0.19 | 0.47 |
| -2.37 | 6.03 | -0.12 | -6.30 | 1.15 | 1.61 |
| -0.31 | 2.22 | -0.17 | -2.58 | -1.14 | 1.98 |
| 0.40 | 0.48 | -0.26 | -1.19 | -0.80 | 1.17 |

$\times \boxed{-0.06}$

$=$

| 31.95 | 18.20 | 19.48 | 20.07 | 18.78 | 31.51 |
| 29.97 | 21.56 | 16.61 | 20.28 | 23.53 | 28.03 |
| 25.52 | 33.86 | 45.37 | 31.85 | 23.23 | 25.54 |
| 25.69 | 23.80 | 19.86 | 22.09 | 25.61 | 23.95 |
| 24.69 | 23.49 | 21.30 | 22.06 | 24.39 | 24.06 |
| 26.06 | 22.40 | 21.40 | 21.61 | 22.68 | 25.86 |

...(3)

The distribution of the internal load yielded by Expression 3 above may correspond to the internal load exerted on the member of interest 200 upon the occurrence of damage on the element of interest 204b.

According to the example embodiment described above, the distribution of the internal load exerted on the member of interest 200 in the sound condition may be preliminarily analyzed by the preliminary analyzer 300, and the results of the analysis may be accumulated in the memory 106. When any of the elements 204a (i.e., the element of interest 204b) is actually damaged, the calculator 104 calculates the distribution of the internal load exerted on the member of interest 200 upon the occurrence of damage on the element of interest 204b.

For example, the calculator 104 may perform addition of the distribution of the internal load exerted in the sound condition and the product of the distribution of the internal load determined by applying an external load and the coefficient calculated on the basis of the damaged portion, to calculate the distribution of the internal load exerted on the member of interest 200 upon the occurrence of damage on the element of interest 204b.

In this way, the distribution of the internal load exerted on the member of interest 200 upon the occurrence of damage on the element of interest 204b may be calculated. This eliminates or reduces the necessity of complicated calculation such as a finite element method after the occurrence of damage on the element 204a.

Accordingly, it is possible to reduce a calculation load on the calculation of the internal load. The distribution of the internal load on the member of interest 200 in the damaged state that is obtained using the method according to the example embodiment may be substantially the same as that obtained using a finite element method without using the method according to the example embodiment.

Some example embodiments of the invention are described above in detail with reference to the accompanying drawings. However, it should be appreciated that the example embodiments of the invention described above are merely illustrative and non-limiting and are not intended to limit the scope of the invention.

It should be also appreciated that various omissions, replacements, and modifications may be made by a person skilled in the art in the foregoing example embodiments described herein, without departing from the scope of the invention. The invention is intended to include such modifications and alterations in so far as they fall within the scope of the appended claims or the equivalents thereof.

In the foregoing example embodiment, the single element of interest 204b is damaged, and the internal load is calculated by deriving the $5 \times 5$ matrix. However, example embodiments of the invention should not limited to the foregoing example embodiment. In another example embodiment of the invention, some of the elements 204a may be damaged, and the internal load may be calculated in the same way as described above. In that case, however, the dimension of the matrix may increase.

In a case where the elements 204a are film elements, the dimension of the matrix to be derived (i.e., the degree of flexibility in load application) may be represented by the following expression: the number of damaged elements $\times$ 5 - the number of sides shared among the damaged elements.

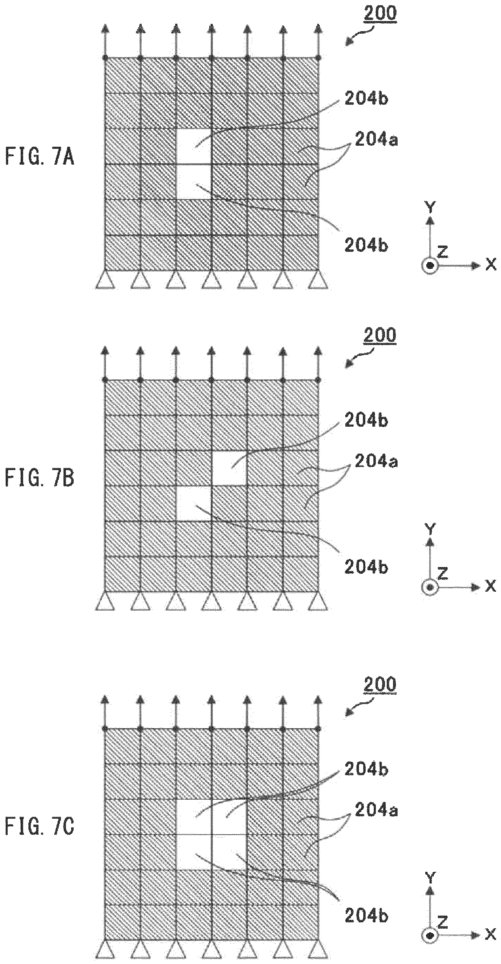

FIGS. 7A to 7C illustrate a first modification example. In an example of FIG. 7A, the number of the elements 204a damaged (i.e., the number of the elements of interest 204b) is "2", and the number of sides shared between the elements of interest 204b is "1".

Therefore, the dimension of the matrix may be "9" ($2 \times 5 - 1 = 9$). In an example of FIG. 7B, the number of the elements 204a damaged (i.e., the number of the elements of interest 204b) is "2", and the number of sides shared between the elements of interest 204b is "0". Therefore, the dimension of the matrix may be "10" ($2 \times 5 - 0 = 10$).

In an example of FIG. 7C, the number of the elements 204a damaged (i.e., the number of the elements of interest 204b) is "4", and the number of sides shared between the elements of interest 204b is "4". Therefore, the dimension of the matrix may be "16" ($4 \times 5 - 4 = 16$).

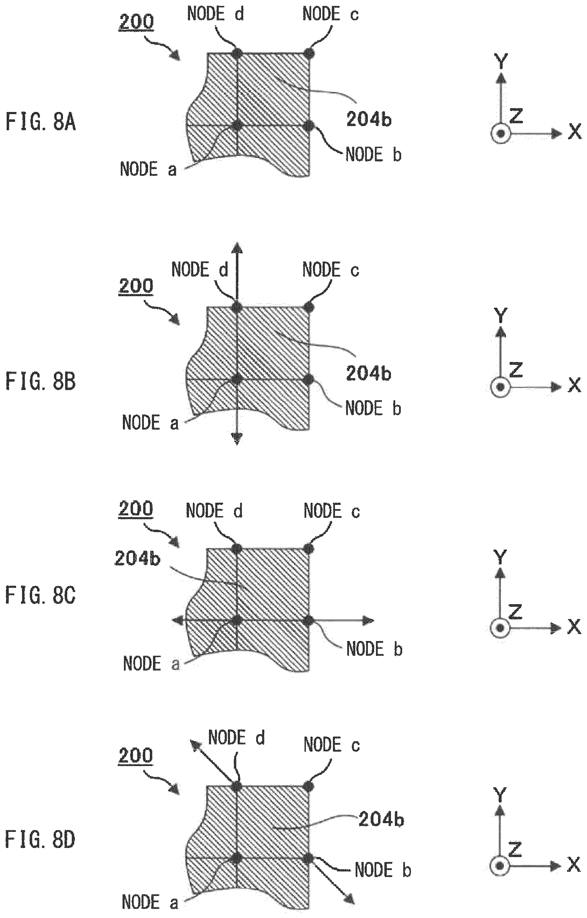

FIGS. 8A to 8D illustrate a second modification example. In FIGS. 8A to 8D, the element 204a damaged or the element of interest 204b is positioned at a corner of the member of interest 200. Hereinafter, the element of interest 204b at a corner of the member of interest 200 may also be referred to as a corner element. In such a case, a load applied to nodes a, b, or d of the corner element is transmitted to the other elements, whereas a load applied to a node c of the corner element may is not transmitted to the other elements.

Therefore, in the case of the corner element, the degree of flexibility in load application may be three in total: a load application in two opposite translational directions in equilibrium as illustrated in FIG. 8B, a load application in two opposite translational directions in equilibrium as illustrated in FIG. 8C, and a load application in two opposite rotational directions in equilibrium as illustrated in FIG. 8D.

Alternatively, the $5 \times 5$ matrix may be derived for the corner element as in the case described above where the single element of interest 204b is damaged. In such a case, the Fx component and the Fy component of the load applied to the node c may each be 0 (zero) N. This eliminates or reduces the necessity of a process dedicated to the corner element, helping to prevent the program from being complicated.

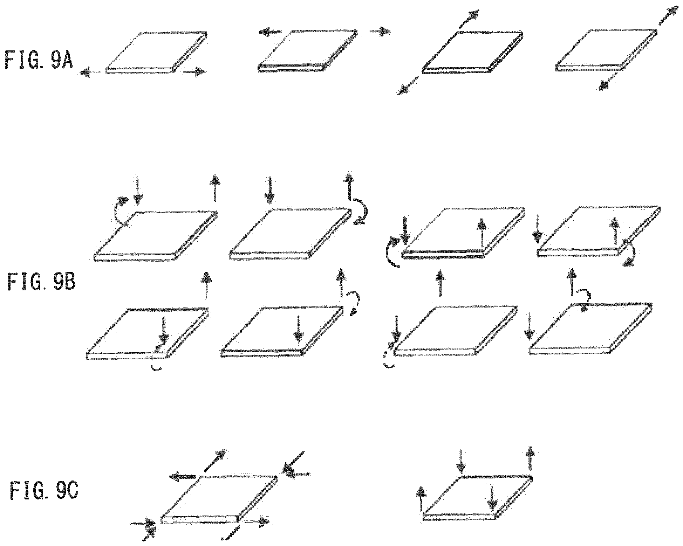

Although the elements 204a are film elements in the foregoing example embodiments, the example embodiments of the invention should not be limited thereto. FIGS. 9A to 9C illustrate a third modification example of the invention. In the third modification example illustrated in FIGS. 9A to 9C, the elements 204a may be plate members having in-plane stiffness and out-of-plane stiffness, for example.

In the case of the plate members, the degree of flexibility in load application may be "14" in total: four patterns of an in-plane tensile load illustrated in FIG. 9A, eight patterns of antiplane shearing and bending illustrated in FIG. 9B, and two patterns of in-plane shearing and in-plane torsion illustrated in FIG. 9C.

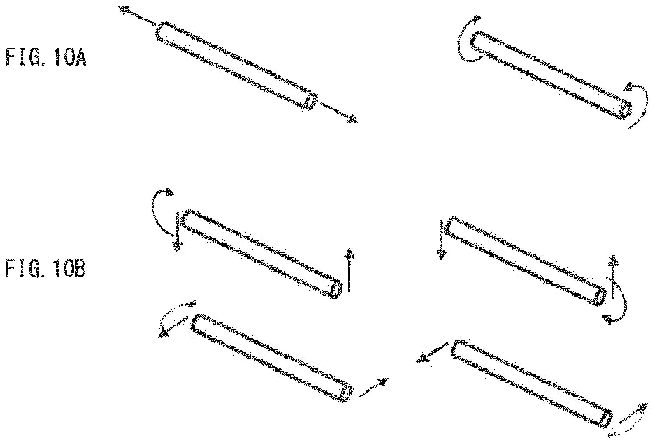

FIGS. 10A and 10B illustrate a fourth modification example of the invention. In the fourth modification example illustrated in FIGS. 10A and 10B, the elements 204a may be bar members having an axial force, bending rigidity, and torsional rigidity. In the case of the bar members, the degree of flexibility in load application may be six in total: an axial force and torsion illustrated in FIG. 10A, and four patterns of shearing and bending illustrated in FIG. 10B.

The calculator 104 illustrated in FIG. 1 is implementable by circuitry including at least one semiconductor integrated circuit such as at least one processor (e.g., a central processing unit (CPU)), at least one application specific integrated circuit (ASIC), and/or at least one field programmable gate array (FPGA). At least one processor is configurable, by reading instructions from at least one machine readable non-transitory tangible medium, to perform all or a part of functions of the calculator 104.

Such a medium may take many forms, including, but not limited to, any type of magnetic medium such as a hard disk, any type of optical medium such as a CD and a DVD, any type of semiconductor memory (i.e., semiconductor circuit) such as a volatile memory and a non-volatile memory. The volatile memory may include a DRAM and a SRAM, and the nonvolatile memory may include a ROM and an NVRAM. The ASIC is an integrated circuit (IC) customized to perform, and the FPGA is an integrated circuit designed to be configured after manufacturing in order to perform, all or a part of the calculator 104 illustrated in FIG. 1.

**Claims**

1.  An internal-load calculation apparatus (100) comprising:

    - a memory (106) configured to store results of a preliminary analysis of an internal load exerted on a member of interest (200) in a sound condition; and
    - a calculator (104) configured to calculate, on a basis of a distribution of an internal load exerted on the member of interest (200) upon an application of an external load to an element of interest (204b) and the results of the preliminary analysis stored in the memory (106), a distribution of an internal load exerted on the member of interest (200) upon an occurrence of damage on the element of interest (204b), the element of interest (204b) corresponding to at least one of a plurality of elements (204a) of the member of interest (200).

2.  The internal-load calculation apparatus (100) according to claim 1, wherein the results of the preliminary analysis include

    - a distribution of an internal load exerted on the member of interest (200) and a load supported at a node of the element of interest (204b) upon an application of a predetermined load to the member of interest (200) in a condition where the element of interest (204b) is not damaged, and
    - a distribution of an internal load exerted on the member of interest (200) and a load supported at the node of the element of interest (204b) upon an application of a predetermined load to the node in the condition where the element of interest (204b) is not damaged.

3.  A method of calculating an internal load comprising:

    - obtaining a distribution of an internal load exerted on a member of interest (200) upon an application of an external load to an element of interest (204b) and results of a preliminary analysis of an internal load exerted on the member of interest (200) in a sound condition, the element of interest (204b) corresponding to at least one of elements of the member of interest (200); and
    - calculating, on a basis of the distribution of the internal load exerted on the member of interest (200) upon the application of the external load to the element of interest (204b) and the results of the preliminary analysis of the internal load exerted on the member of interest (200) in the sound condition, a distribution of an internal load exerted on the member of interest (200) upon an occurrence of damage on the element of interest (204b).

4.  The method according to claim 3,
    wherein the results of the preliminary analysis include

    - a distribution of an internal load exerted on the member of interest (200) and a load supported at a node of the element of interest (204b) upon an application of a predetermined load to the member of interest (200) in a condition where the element of interest (204b) is not damaged, and
    - a distribution of an internal load exerted on the member of interest (200) and a load supported at the node of the element of interest (204b) upon an application of a predetermined load to the node in the condition where the element of interest (204b) is not damaged.

FIG. 1

FIG. 2

FIG. 3A

204b

| 31.57 | 18.35 | 20.08 | 20.08 | 18.35 | 31.57 |
| 28.47 | 21.69 | 19.84 | 19.84 | 21.69 | 28.47 |
| 25.53 | 23.16 | 21.31 | 21.31 | 23.16 | 25.53 |
| 23.75 | 23.56 | 22.69 | 22.69 | 23.56 | 23.75 |
| 23.21 | 23.88 | 22.91 | 22.91 | 23.88 | 23.21 |
| 25.11 | 22.62 | 22.28 | 22.28 | 22.62 | 25.11 |

204b

FIG. 3B

204b

| 0.28 | −0.32 | −0.28 | 0.25 | 0.20 | −0.12 |
| 1.35 | −1.45 | −1.53 | 1.91 | −0.08 | −0.20 |
| −0.47 | 10.34 | 10.44 | −0.47 | 0.46 | −0.31 |
| 1.72 | −1.69 | −1.84 | 1.84 | 0.03 | −0.06 |
| 0.88 | −0.73 | −0.78 | 0.12 | 0.44 | 0.07 |
| 0.48 | −0.24 | −0.45 | −0.14 | 0.13 | 0.22 |

204b

NODE 4
fx = 0N
fy = 100N

NODE 1
fx = 0N
fy = −100N

−0.31

FIG. 3C

204b

| 0.04 | 0.26 | −0.31 | −0.31 | 0.26 | 0.04 |
| −0.32 | 1.86 | −1.54 | 1.54 | 1.86 | −0.32 |
| 0.12 | −0.49 | 10.37 | 10.37 | −0.49 | 0.12 |
| 0.06 | 1.80 | −1.86 | −1.86 | 1.80 | 0.06 |
| 0.66 | 0.18 | −0.85 | −0.85 | 0.18 | 0.66 |
| 0.55 | −0.05 | −0.51 | −0.51 | −0.05 | 0.55 |

204b

NODE 3
fx = 0N
fy = 100N

NODE 2
fx = 0N
fy = −100N

FIG. 3D

204b

| −0.06 | 0.05 | 0.08 | −0.01 | −0.05 | 0.00 |
| −0.24 | 0.18 | 0.33 | 0.06 | −0.82 | 0.29 |
| 0.87 | −1.27 | 1.08 | −1.39 | 0.22 | 0.49 |
| 0.74 | −1.24 | 1.20 | −1.30 | 0.22 | 0.38 |
| −0.66 | 0.31 | 0.67 | 0.33 | −0.63 | −0.03 |
| −0.71 | 0.25 | 0.67 | 0.31 | 0.02 | −0.53 |

204b

NODE 1          NODE 2
fx = −100N    fx = 100N
fy = 0N          fy = 0N

FIG. 3E

204b

| −0.03 | −0.07 | 0.27 | −0.04 | −0.39 | 0.26 |
| 1.03 | −1.37 | 0.92 | −1.40 | 0.31 | 0.52 |
| 0.86 | −1.28 | 1.08 | −1.36 | 0.25 | 0.45 |
| −0.52 | 0.28 | 0.54 | 0.23 | −0.61 | 0.08 |
| −0.49 | 0.19 | 0.47 | 0.21 | −0.03 | −0.34 |
| −0.42 | 0.12 | 0.34 | 0.29 | 0.01 | −0.34 |

NODE 4          NODE 3
fx = −100N    fx = 100N
fy = 0N          fy = 0N

204b

FIG. 3F

204b

| 0.58 | −1.35 | −0.07 | 1.16 | 0.13 | −0.46 |
| 2.79 | −5.55 | −0.21 | 5.20 | −1.78 | −0.45 |
| 0.26 | 0.10 | −0.19 | −0.44 | −0.19 | 0.47 |
| −2.37 | 6.03 | −0.12 | −6.30 | 1.15 | 1.61 |
| −0.31 | 2.22 | −0.17 | −2.58 | −1.14 | 1.98 |
| 0.40 | 0.48 | −0.26 | −1.19 | −0.60 | 1.17 |

NODE 4          NODE 3
fx = −100N    fx = −100N
fy = 100N     fy = −100N

204b

NODE 1          NODE 2
fx = 100N     fx = 100N
fy = 100N     fy = −100N

FIG. 4A

| | Fx | Fy |
|---|---|---|
| NODE 1 | 2.01 | 51.39 |
| NODE 2 | -6.56 | 55.15 |
| NODE 3 | -2.08 | -50.61 |
| NODE 4 | 6.62 | -55.93 |

FIG. 4B

| | Fx | Fy |
|---|---|---|
| NODE 1 | 2.70 | 36.34 |
| NODE 2 | -2.74 | 15.84 |
| NODE 3 | -2.67 | -15.82 |
| NODE 4 | 2.71 | -36.38 |

NODE 4
fx=0N
fy=100N

NODE 1
fx=0N
fy=-100N

FIG. 4C

| | Fx | Fy |
|---|---|---|
| NODE 1 | 2.93 | 15.94 |
| NODE 2 | -2.49 | 35.91 |
| NODE 3 | -2.93 | -36.35 |
| NODE 4 | 2.49 | -15.50 |

NODE 3
fx=0N
fy=100N

NODE 2
fx=0N
fy=-100N

FIG. 4D

| | Fx | Fy |
|---|---|---|
| NODE 1 | 36.11 | 2.72 |
| NODE 2 | -36.07 | -2.88 |
| NODE 3 | -15.72 | -2.72 |
| NODE 4 | 15.68 | -2.88 |

NODE 1
fx=-100N
fy=0N

NODE 2
fx=100N
fy=0N

FIG. 4E

| | Fx | Fy |
|---|---|---|
| NODE 1 | 15.70 | 2.55 |
| NODE 2 | -15.98 | 2.87 |
| NODE 3 | -36.23 | -2.59 |
| NODE 4 | 36.51 | -2.83 |

NODE 4
fx=-100N
fy=0N

NODE 3
fx=100N
fy=0N

FIG. 4F

| | Fx | Fy |
|---|---|---|
| NODE 1 | -63.59 | -63.88 |
| NODE 2 | -63.62 | 62.91 |
| NODE 3 | 63.31 | 64.29 |
| NODE 4 | 63.90 | -63.33 |

NODE 4
fx=-100N
fy=100N

NODE 3
fx=-100N
fy=100N

NODE 1
fx=100N
fy=100N

NODE 2
fx=100N
fy=-100N

11

START

IS ANY
ELEMENT DAMAGED
?

S101

NO

YES

S103

DETECT DAMAGED PORTION

S105

RETRIEVE RESULTS OF
PRELIMINARY ANALYSIS

S107

EXTRACT PREDETERMINED NUMBER
OF PIECES OF INFORMATION

S109

CALCULATE INVERSE MATRIX

S111

EXTRACT PREDETERMINED NUMBER
OF PIECES OF INFORMATION

S113

PERFORM CALCULATION OF MATRIX

S115

CALCULATE INTERNAL LOAD

END

FIG. 5

(A)

| | | | Fx | | | | Fy | | | |
|---|---|---|---|---|---|---|---|---|---|---|
| | | | NODE 1 | NODE 2 | NODE 3 | NODE 4 | NODE 1 | NODE 2 | NODE 3 | NODE 4 |
| EXTERNAL LOAD | | (1) | 0.00 | 0.00 | 0.00 | 0.00 | 0.00 | 0.00 | 0.00 | 0.00 |
| | | (2) | 0.00 | 0.00 | 0.00 | 0.00 | -100.00 | 0.00 | 0.00 | 100.00 |
| | | (3) | 0.00 | 0.00 | 0.00 | 0.00 | 0.00 | -100.00 | 100.00 | 0.00 |
| | | (4) | -100.00 | 100.00 | 0.00 | 0.00 | 0.00 | 0.00 | 0.00 | 0.00 |
| | | (5) | 0.00 | 0.00 | 100.00 | -100.00 | 0.00 | 0.00 | 0.00 | 0.00 |
| | | (6) | 100.00 | 100.00 | -100.00 | -100.00 | 100.00 | -100.00 | -100.00 | 100.00 |
| LOAD SUPPORTED BY ELEMENT OF INTEREST | | (1) | 2.01 | -6.56 | -2.08 | 6.62 | 51.39 | 55.15 | -50.61 | -55.93 |
| | | (2) | 2.70 | -2.74 | -2.67 | 2.71 | 36.34 | 15.85 | -15.82 | -36.38 |
| | | (3) | 2.93 | -2.49 | -2.93 | 2.49 | 15.94 | 35.91 | -36.35 | -15.50 |
| | | (4) | 36.11 | -36.07 | -15.72 | 15.68 | 2.72 | 2.86 | -2.72 | -2.68 |
| | | (5) | 15.70 | -15.98 | -36.23 | 36.51 | 2.55 | 2.87 | -2.59 | -2.83 |
| | | (6) | -63.59 | -63.62 | 63.31 | 63.90 | -63.88 | 62.91 | 64.29 | -63.33 |
| LOAD EXERTED ON ELEMENTS SURROUNDING ELEMENT OF INTEREST | | (1) | 2.01 | -6.56 | -2.08 | 6.62 | 51.39 | 55.15 | -50.61 | -55.93 |
| | | (2) | 2.70 | -2.74 | -2.67 | 2.71 | -63.66 | 15.85 | -15.82 | 63.62 |
| | | (3) | 2.93 | -2.49 | -2.93 | 2.49 | 15.94 | -64.09 | 63.65 | -15.50 |
| | | (4) | -63.89 | 63.93 | -15.72 | 15.68 | 2.72 | 2.68 | -2.72 | -2.68 |
| | | (5) | 15.70 | -15.98 | 63.77 | -63.49 | 2.55 | 2.87 | -2.59 | -2.83 |
| | | (6) | 36.41 | 36.38 | -36.69 | -36.10 | 36.12 | -37.09 | -35.71 | 38.67 |

(B)

| | | (2) | (3) | (4) | (5) | (6) |
|---|---|---|---|---|---|---|
| Fx | NODE 1 | 2.70 | 2.93 | -63.89 | 15.70 | 36.41 |
| | NODE 2 | -2.74 | -2.49 | 63.93 | -15.98 | 36.38 |
| | NODE 3 | -2.67 | -2.93 | -15.72 | 63.77 | -36.69 |
| Fy | NODE 1 | -63.66 | 15.94 | 2.72 | 2.55 | 36.12 |
| | NODE 2 | 15.85 | -64.09 | 2.68 | 2.87 | -37.09 |

FIG. 6

FIG. 7A

FIG. 7B

FIG. 7C

FIG. 8A

FIG. 8B

FIG. 8C

FIG. 8D

FIG. 9A

FIG. 9B

FIG. 9C

FIG. 10A

FIG. 10B

Europäisches
Patentamt

European
Patent Office

Office européen
des brevets

## EUROPEAN SEARCH REPORT

Application Number

EP 21 15 0560

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/371989 A1 (LESTER ERIC S [US] ET AL) 28 December 2017 (2017-12-28)<br>* the whole document *<br>* figures 1,12 *<br>* paragraph [0009] - paragraph [0015] *<br>* paragraph [0012] *<br>* paragraph [0061] - paragraph [0064] *<br>----- | 1-4 | INV.<br>G06F30/23 |
| X | US 2019/204854 A1 (YOSHIMURA KENSUKE [JP]) 4 July 2019 (2019-07-04)<br>* the whole document *<br>* figure 1 *<br>* paragraph [0006] *<br>* paragraph [0027] - paragraph [0030] *<br>* paragraph [0028] *<br>----- | 1-4 | |
| X | GOWDA T ET AL: "Optimization of Design Parameters of Aircraft Wing Structure with Large Cut Outs using Damage Tolerant Design and Finite element analysis Approach",<br>INTERNATIONAL JOURNAL OF RECENT TECHNOLOGY AND ENGINEERING IJRTE,<br>vol. 8, 1 May 2019 (2019-05-01), pages 128-132, XP055816851,<br>ISSN: 2277-3878<br>* the whole document *<br>* abstract *<br>* tables 1,2 *<br>* section II.B *<br>* section II.D *<br>* section III.E *<br>----- <br> -/-- | 1-4 | TECHNICAL FIELDS SEARCHED (IPC)<br><br>G06F |

The present search report has been drawn up for all claims

| Place of search | Date of completion of the search | Examiner |
|---|---|---|
| Munich | 22 June 2021 | Rungger, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 21 15 0560

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JANG JUN HWAN ET AL: "FE Modeling Methodology for Load Analysis and Preliminary Sizing of Aircraft Wing Structure", INTERNATIONAL JOURNAL OF AVIATION, AERONAUTICS, AND AEROSPACE, 1 March 2019 (2019-03-01), XP055816857, DOI: 10.15394/ijaaa.2019.1301 * the whole document * * abstract * * figure 1 * * figures 12,13,14 * * page 1, paragraph 3 * * pages 3 and 4 * * page 19 * * page 19, paragraph 2 * ----- | 1-4 | |

TECHNICAL FIELDS
SEARCHED      (IPC)

The present search report has been drawn up for all claims

| Place of search | Date of completion of the search | Examiner |
|---|---|---|
| Munich | 22 June 2021 | Rungger, Matthias |

EPO FORM 1503 03.82 (P04C01)

page 2 of 2

## ANNEX TO THE EUROPEAN SEARCH REPORT
## ON EUROPEAN PATENT APPLICATION NO.

EP 21 15 0560

This annex lists the patent family members relating to the patent documents cited in the above-mentioned European search report.
The members are as contained in the European Patent Office EDP file on
The European Patent Office is in no way liable for these particulars which are merely given for the purpose of information.

22-06-2021

| Patent document cited in search report | Publication date | Patent family member(s) | Publication date |
|---|---|---|---|
| US 2017371989 A1 | 28-12-2017 | NONE | |
| US 2019204854 A1 | 04-07-2019 | CN 109641666 A | 16-04-2019 |
| | | EP 3521176 A1 | 07-08-2019 |
| | | JP 6374609 B1 | 15-08-2018 |
| | | JP WO2018061280 A1 | 27-09-2018 |
| | | US 2019204854 A1 | 04-07-2019 |
| | | WO 2018061280 A1 | 05-04-2018 |

**EP 3 866 046 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018061280 A1